Europäisches Patentamt

European Patent Office

Office européen des brevets

(11) Veröffentlichungsnummer: **0 249 834**
**A2**

(19)

(12) **EUROPÄISCHE PATENTANMELDUNG**

(21) Anmeldenummer: **87108195.6**

(51) Int. Cl.⁴: **H05K 3/02**

(22) Anmeldetag: **05.06.87**

(30) Priorität: **20.06.86 DE 3620628**

(43) Veröffentlichungstag der Anmeldung:
**23.12.87 Patentblatt 87/52**

(84) Benannte Vertragsstaaten:
**CH DE FR GB LI**

(71) Anmelder: **Siemens Aktiengesellschaft Berlin
und München
Wittelsbacherplatz 2
D-8000 München 2(DE)**

(72) Erfinder: **Gröber, Alfred
Maria-Eich Strasse 20
D-8035 Gauting(DE)**
Erfinder: **Hadersbeck, Hans
Pistorinistrasse 14
D-8000 München 9(DE)**
Erfinder: **Müller, Fritz
Lipowskistrasse 14
D-8000 München 70(DE)**
Erfinder: **Zukier, Hubert
Wilhelm-Busch-Strasse 30
D-8000 München 71(DE)**
Erfinder: **Hacke, Hans Jürgen
Malojaweg 7
D-8000 München 71(DE)**

(54) **Herstellung von Feinstrukturen für die Halbleiterkontaktierung.**

(57) Die phototechnische Strukturierung wird beidseitig an einem glatten, unverspannten Metallband 1 durchgeführt. Das Band wird von beiden Seiten geätzt. Durch eine spezielle Schwimmgalvanik sind einseitige Metallabscheidungen möglich. Die Stabilisierung der Feinstruktur 2 wird durch elektrophoretische Lackabscheidung bzw. durch Elektrotauchlackierung 9 zwischen den Leitern erreicht. Der Isolierstoffträger 6 wird erst in der Endphase der Herstellung aufgebracht.

## FIG 2

## Herstellung von Feinstrukturen für die Halbleiterkontaktierung.

Die Erfindung betrifft ein Verfahren zur Herstellung von Feinstrukturen für die Halbleiterkontaktierung, vorzugsweise in Bandform, insbesondere für die Kontaktierung höchstpoliger Halbleiter.

Halbleiterchips werden üblicherweise mit feinen Drähten auf Systemträger kontaktiert, die dann zu Gehäusen umspritzt werden.

Eine weitere Methode ist die über vorgefertigte Strukturen, sogenannte Zwischensubstrate oder Spider. Bei diesem TAB (tape automated bonding) genannten Verfahren wird zunächst der Halbleiterchip mit allen seinen Anschlüssen gleichzeitig in den Innenbereich der Feinstruktur kontaktiert (Innenkontaktierung) und dann vom Anwender über den Außenbereich der Feinstruktur mit der Verdrahtung verbunden (Außenkontaktierung). Diese Bauform ist extrem klein, flach und leicht. Sie wird zunehmend bei höchstpoligen Halbleiterbausteinen angewandt, bei denen eine Kontaktierung auf herkömmlichem Wege nicht mehr möglich oder unvorteilhaft ist. Allerdings steigen bei derartigen Bausteinen mit einigen hundert Anschlüssen im Raster von zum Beispiel <150 μm die Anforderungen an die Feinstruktur so stark, daß sie mit üblichen Herstellverfahren nicht mehr erfüllt werden können.

Für die Herstellung von Feinstrukturen an sich gibt es mehrere Verfahren.

Ein übliches Verfahren zur Herstellung eines sogenannten 3-Lagen-Bandes, das zum Beispiel in Solid State Technology 3.78 "Beam Tape Carriers - A Design Guide" abgedruckt ist, sieht zunächst das Stanzen der Öffnungen in das kleberbeschichtete Kunststoffband vor, auf das dann Kupfer laminiert wird. Dieses Band wird mit Photolack beschichtet, auf der Kupferseite mit dem Negativmuster der Feinstruktur belichtet, entwickelt und dann in Form der Struktur galvanisch, zum Beispiel mit Zinn, belegt. Nach Entschichtung wird das Band mit der galvanisch abgeschiedenen Oberfläche als Ätzschutz geätzt.

Nachteilig bei diesem Verfahren ist die ausgeprägte Schüsselbildung beim Laminieren des Kupfers über große Öffnungen des Kunststoffbandes, die eine genaue phototechnische Strukturerzeugung verhindert. Auch die Beschichtung mit Photolack ist auf der Bandrückseite mit den Öffnungen nicht gleichmäßig möglich, was die Lacktrocknung behindert und später zu unkontrollierten Fehlern durch Lackabplatzen und Galvanikdurchschlägen führt.

Bei weiteren, bekannten Verfahren werden die Öffnungen im Kunststoffband durch Ätzen bzw. Herauslösen des Kunststoffes hergestellt und die Leiterstrukturen gegebenenfalls durch additiven Metallaufbau erzeugt.

Der Erfindung liegt die Aufgabe zugrunde, das eingangs genannte Verfahren zu konzipieren, mit dem folgende Forderungen an Feinstrukturen zur Kontaktierung auch höchstpoliger Halbleiter zu erfüllen sind:

Ausreichender Leiterquerschnitt bei 35 μm Dicke trotz engster Teilung.

Innen- und Außenkontaktierung auf verschiedenen Seiten der Feinstruktur und damit unterschiedliche Oberflächen in definierten Bereichen.

Stabilisierung der Feinstruktur, um Biegevorgänge ohne Rasteränderung durchführen zu können.

Ein Kunststoffträger muß als Justierhilfe dienen und die elektrische Prüfung ermöglichen.

Diese Aufgabe wird durch die Merkmale der Patentansprüche gelöst. Unter Elektrophorese versteht man die Bewegung von kolloidalen Teilchen unter der Einwirkung eines elektrischen Stromes.

Das glatte Band gestattet eine gleichmäßige und problemlose Lackbeschichtung. Verwölbungen und Knicke treten nicht auf.

Durch die beidseitige phototechnische Strukturierung sind die Voraussetzungen für Reproduzierbarkeit und genaue Zuordnung beider Seiten gegeben. Durch die beiderseitige Ätzung wird die Gesamtunterätzung verringert und bei gleicher Metalldicke eine feinere Struktur als bei einseitiger Ätzung erreicht.

Durch eine spezielle Schwimmgalvanik sind einseitige Metallabscheidungen möglich.

Die elektrophoretische Lackabscheidung bzw. Elektrotauchlackierung ermöglicht die rastergetreue Herstellung und spätere Verformung auch extrem feiner Strukturen.

Da der Isolierstoffträger erst in der Endphase der Herstellung aufgebracht wird, wird die Herstellqualität dadurch nicht beeinträchtigt.

Der Verfahrensablauf geht zum Beispiel folgendermaßen vor sich:

1. Reinigen des Metallbandes (zum Beispiel Kupfer 35 μm dick),

2. Beidseitiges Beschichten des Bandes mit Photolack;

3. Beidseitiges Belichten (Oberseite Galvanikmaske, Unterseite Ätzabdeckung),

4. Beidseitiges Entwickeln,

5. Einseitige galvanische Metallabscheidung (zum Beispiel Zinn auf der Bandoberseite für die spätere Innenkontaktierung) mit Schwimmgalvanik. Statt der Galvanikmaske, das heißt anstelle von Metallresist, kann auch eine Ätzmaske, das heißt eine Photolackabdeckung, aufgebracht werden,

6. Einseitiges Ätzen der Unterseite auf zum Beispiel 50 Prozent der Dicke, gegebenenfalls in einem Ätzkanal.

7. Elektrophoretische Lackabscheidung (bzw. Elektrotauchlackierung) in die tiefgeätzten Bereiche zwischen den Leiterbahnen mit einem Lack, der resistent gegen Entschichter ist.

8. Zweite fototechnische Strukturierung unter der Voraussetzung einer positiv arbeitenden Photolackabdeckung.

9. Nachbelichten des für eine Sondermetallisierung vorgesehenen Bereiches auf der Unterseite (zum Beispiel für die Außenkontaktierung).

10. Entwickeln dieses Bereiches.

11. Einseitige galvanische Metallabscheidung auf der Unterseite (zum Beispiel SnPb).

12. Beidseitiges Entschichten des Photolackes.

13. Aufbringen einer Kunststoffstabilisierung auf die Bandunterseite entweder durch Auflaminieren vorgestanzter Trägerplättchen oder durch Siebdruck relativ dicker Lackschichten.

14. Fertigätzen (Ätzkanal) der Struktur von der Oberseite.

15. Vereinzeln.

Das Verfahren kann auch ohne die elektrophoretische Lackabscheidung bzw. Elektrotauchlackierung zur Versteifung und ohne die Sondermetallisierung (Position 7 bis 11) durchgeführt werden.

Das Verfahren kann dahingehend abgeändert werden, daß bei der phototechnischen Strukturierung statt der Galvanisiermaske eine Ätzmaske ausgebildet wird und im Ätzkanal auf der Unterseite in halber Tiefe geätzt wird. Darauf erfolgt die elektrophoretische Lackabscheidung in die tief geätzten Bereiche zwischen den Leiterbahnen bzw. Elektrotauchlackierung.

Nach der elektrophoretischen Beschichtung bzw. der Elektrotauchlackierung wird die Oberseite fertig geätzt. Nach dem Fertigätzen erfolgt auch auf der Oberseite eine elektrophoretische Abscheidung bzw. Elektrotauchlackierung. Dadurch werden die nach dem Ätzen der Oberseite freiliegenden Leiterbahnflanken auch mit elektrophoretischem Lack bedeckt.

Nach dem Entschichten des Photolackes wird auf der Oberseite auf den freiliegenden Metallschichten Metall, vorzugsweise Zinn, abgeschieden. Das geschieht ebenfalls mittels der Schwimmgalvanik.

Nach der einseitigen Metallabscheidung wird eine Kunststoffstabilisierung in Einzelstücken aufgebracht. Statt der Kunststoffstabilisierung in Form von aus einer Folie gestanzten Einzelstücken kann auch ein Siebdrucklack aufgebracht werden.

Die Erfindung wird anhand eines in den Figuren dargestellten Ausführungsbeispiels erläutert. Es zeigen:

Figur 1 ein einzelnes Teil in der Draufsicht und

Figur 2 einen teilweisen Schnitt durch Figur 1.

Als Ausgangsmaterial dient ein Metallband 1. Die Strukturen sind mit 2 bezeichnet und setzen sich zusammen aus Leiterbahnen, die der Länge nach den Innenanschlußbereich 3 neben der Mittenabfangung, den Außenanschlußbe reich 4 und den Testanschlußbereich 5 umfassen. Mit 6 ist eine Kunststoffstabilisierung aus einer Kunststofffolie bezeichnet, die als Einzelstück vor der letzten Ätzung auf die Feinstruktur aufgebracht wird.

In der Kunststoffstabilisierung und im Kupferband können Perforationslöcher 7 und Justierlöcher 8 für die Weiterverarbeitung eingebracht sein.

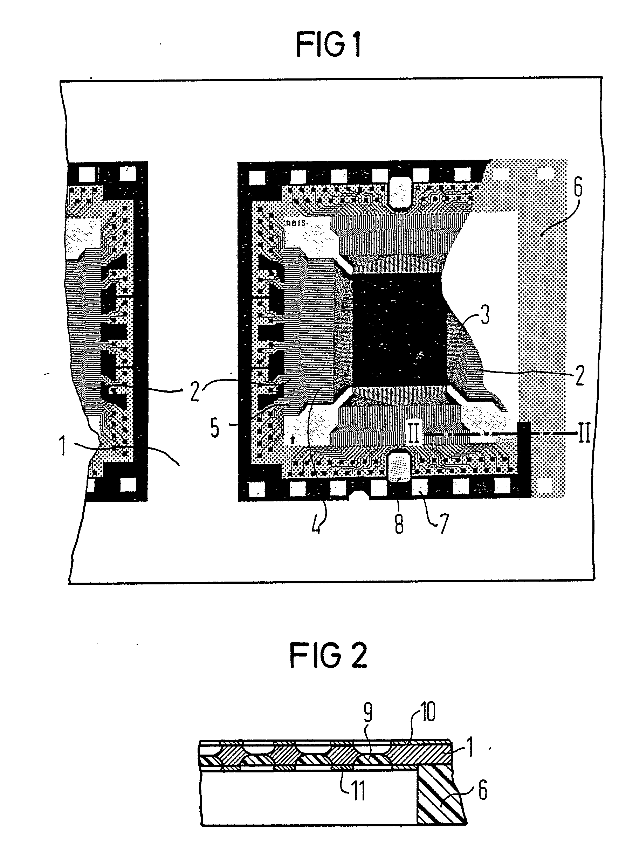

Die Figur 2 zeigt zusätzlich den elektrophoretisch bzw. durch Elektrotauchlackierung abgeschiedenen Lack 9. Auf der Oberseite des Kupfers 1 ist vorzugsweise Zinn 10 und auf der Unterseite gegebenenfalls in gewünschten Bereichen SnPb 11 aufgebracht.

Nach dem erfindungsgemäßen Verfahren hergestellte Feinstrukturen erfüllen durch vorteilhafte Kombination von Verfahrensschritten und Maßnahmen alle Forderungen an eine Feinstruktur zur Kontaktierung höchstpoliger Halbleiter.

Bezugszeichenliste

1 Metallband
2 Feinstrukturen
3 Innenanschlußbereich
4 Außenanschlußbereich
5 Testanschlußbereich
6 Kunststoffstabilisierung
7 Perforationslöcher
8 Justierlöcher
9 Lack
10 Zinn
11 Zinn-Blei

**Ansprüche**

1. Verfahren zur Herstellung von Feinstrukturen für die Halbleiterkontaktierung, vorzugsweise in Bandform, insbesondere für die Kontaktierung höchstpoliger Halbleiter, **dadurch gekennzeichnet,** daß als Ausgangsmaterial ein glattes, unverspanntes Metallband (1) dient, das nach dem Reinigen beidseitig phototechnisch strukturiert (2) wird, darauf nur auf der Oberseite galvanisch in einer sogenannten Schwimmgalvanik Metall (10) abgeschieden und auf der Unterseite in halber Tiefe geätzt wird, daß anschließend beidseitig entschichtet und auf der Unterseite eine Kunststoffstabilisierung (6) in Einzelstücken aufgebracht und die Oberseite in einem besonderen Ätzkanal fertiggeätzt wird.

2. Verfahren nach Anspruch 1, **dadurch gekennzeichnet,** daß nach dem einseitigen Ätzen auf der Unterseite elektrophoretisch bzw. durch Elektrotauchlackierung ein gegen Entschichter resistenter Lack (9) in die tief geätzten Bereiche zwischen den Leiterbahnen abgeschieden wird.

3. Verfahren nach den Ansprüchen 1 und 2 unter der Voraussetzung einer positiv arbeitenden Photolackabdeckung, **dadurch gekennzeichnet,** daß nach der elektrophoretischen Lackabscheidung bzw. Elektrotauchlackierung auf der Unterseite eine zweite phototechnische Strukturierung und eine einseitige galvanische Metallabscheidung (11) erfolgt.

4. Verfahren nach Anspruch 1, **dadurch gekennzeichnet,** daß in der Schwimmgalvanik der Elektrolyt in einen Zwischenbehälter gepumpt wird, auf dessen offener Oberseite ein Schwall entsteht, der nur einseitig mit dem Band in Berührung kommt.

5. Verfahren nach Anspruch 1, **dadurch gekennzeichnet,** daß im Ätzkanal das Metallband (1) in Führungsnuten mit breiten Schirmflächen durchgezogen wird.

6. Verfahren nach Anspruch 1, **dadurch gekennzeichnet,** daß bei der phototechnischen Strukturierung statt der Galvanisiermaske eine Ätzmaske ausgebildet wird und im Ätzkanal auf der Unterseite in halber Tiefe geätzt wird.

7. Verfahren nach Anspruch 2, **dadurch gekennzeichnet,** daß nach der elektrophoretischen Beschichtung bzw. der Elektrotauchlackierung die Oberseite fertiggeätzt wird.

8. Verfahren nach Anspruch 7, **dadurch gekennzeichnet,** daß nach dem Fertigätzen auch auf der Oberseite eine elektrophoretische Abscheidung bzw. Elektrotauchlackierung erfolgt.

9. Verfahren nach Anspruch 8, **dadurch gekennzeichnet,** daß nach dem Entschichten des Photolackes auf der Oberseite auf den freiliegenden Metallschichten Metall, vorzugsweise Zinn, abgeschieden wird.

10. Verfahren nach den Ansprüchen 1 und 9, **dadurch gekennzeichnet,** daß nach der einseitigen Metallabscheidung eine Kunststoffstabilisierung in Einzelstücken bzw. mittels Siebdruck eine Lackschicht aufgebracht wird.

## FIG 1

## FIG 2